# EUROPÄISCHE PATENTSCHRIFT

(11) **EP 1 816 747 B1**
(45) Veröffentlichungstag und Bekanntmachung des Hinweises auf die Patenterteilung: **06.04.2011**
(21) Anmeldenummer: 07002162.1
(22) Anmeldetag: 01.02.2007
(51) Int. Cl.: H03K 17/96

(54) **Kapazitiver Berührungsschalter**
Capacitive touch switch
Commutateur tactile capacitif

(30) Priorität: 06.02.2006 DE 102006005581
(43) Veröffentlichungstag der Anmeldung: 08.08.2007
(73) Patentinhaber: Diehl AKO Stiftung & Co. KG, 88239 Wangen (DE)
(72) Erfinder: Raunig, Bernd, 12279 Berlin (DE)
(74) Vertreter: Diehl Patentabteilung

(56) Entgegenhaltungen:
- EP-A- 0 262 909
- EP-A- 0 858 166
- WO-A-2007/025851
- DE-A1- 2 942 097

## Beschreibung

Die vorliegende Erfindung betrifft einen kapazitiven Berührungsschalter nach Anspruch 1, der in einer Bedienungseinrichtung für ein elektronisches Haushaltsgerät einsetzbar ist.

In vielen elektronischen Geräten, insbesondere auch in Haushaltsgeräten wie Herden, Kochfeldern, Mikrowellenöfen, Spülmaschinen, Waschmaschinen, Wäschetrocknern und dergleichen, werden häufig Berührungsschalter eingesetzt, die durch ein einfaches Berühren durch einen Benutzer einen bestimmten Schaltvorgang im Gerät auslösen. Im Fall eines kapazitiven Berührungsschalters weist dieser eine Sensorfläche auf, die als Teil eines kapazitiven Sensorelements zusammen mit dem Benutzer eine Kapazität bildet, die sich entsprechend dem Betätigen, d.h. dem Berühren oder Nicht-Berühren des Berührungsschalters verändert.

Ein solcher Berührungsschalter, der ein nachteiliges, störungsempfindliches Ausgangssignal bereitstellt, ist aus der der EP 0 858 166 A1 bekannt. Der kapazitive Berührungsschalter weist eine Sensorfläche als Teil eines kapazitiven Sensorelements, dessen Kapazität sich bei Berührung verändert und eine Messelektrode auf, die mit der Sensorfläche gekoppelt ist, auf einer Leiterplatte angeordnet ist und auf einem ersten Potential liegt, wobei der Berührungsschalter weiter eine Zusatzelektrode aufweist, die nahe der Messelektrode ebenfalls auf der Leiterplatte angeordnet ist, von der Messelektrode elektrisch isoliert ist und auf einem von dem ersten Potential verschiedenen zweiten Potential liegt.

Die DE 10 2005 001 777 A1 der Anmelderin (Stand der Technik im Sinne von § 3 Absatz 2 PatG) beschreibt eine spezielle Schaltungsanordnung für einen kapazitiven

Berührungsschalter mit relativ einfachem Aufbau und gleichzeitig zuverlässigem Ausgangssignal. Weitere herkömmliche kapazitive Berührungsschalter sind dem Fachmann aus der Praxis und einer Vielzahl von Druckschriften bekannt.

Der vorliegenden Erfindung liegt die Aufgabe zugrunde, einen kapazitiven Berührungsschalter mit einer Schaltungsanordnung zu entwickeln, die ein weniger störungsempfindliches Ausgangssignal erzeugt.

Diese Aufgabe wird durch einen kapazitiven Berührungsschalter mit einer Schaltungsanordnung mit den Merkmalen des Anspruchs 1 gelöst. Vorteilhafte Ausgestaltungen und Weiterbildungen der Erfindung sind Gegenstand der abhängigen Ansprüche.

Die vorliegende Erfindung umfasst einen kapazitiven Berührungsschalter, mit einer Sensorfläche als Teil eines kapazitiven Sensorelements, dessen Kapazität sich bei Berührung verändert, und einer Messelektrode, die mit der Sensorfläche gekoppelt ist und auf einer Leiterplatte angeordnet ist, sowie eine Schaltungsanordnung, mit einer den Berührungsschalter enthaltenden Sensorschaltung und einer Auswerteschaltung, der ein Ausgangssignal der Sensorschaltung zum Bestimmen, ob der Berührungsschalter betätigt wird oder nicht, zugeführt wird. Die Sensorschaltung enthält dabei eine erste Spannungsquelle zum Liefern einer Betriebsspannung, einen ersten pnp-Transistor, dessen Basis über einen ersten Widerstand mit der Messelektrode und über einen zweiten Widerstand mit dem Pluspol der Betriebsspannung verbunden ist und dessen Emitter über einen dritten Widerstand auch mit dem Pluspol der Betriebsspannung verbunden ist, eine zweite Spannungsquelle zum Liefern einer Pulsspannung, die zwischen dem Kollektor des ersten pnp-Transistors und einem mit dem Minuspol der Betriebsspannung verbundenen Bezugspotential angelegt ist, und einen zweiten pnp-Transistor, dessen Basis mit dem Emitter des ersten pnp-Transistors verbunden ist, dessen Kollektor auch mit dem Bezugspotential (zum Beispiel Masse) verbunden ist und dessen Emitter über eine Parallelschaltung aus einem vierten Widerstand und einer Kapazität mit dem Pluspol der Betriebsspannung verbunden ist, wobei eine Zusatzelektrode mit dem Kollektor des ersten pnp-Transistors verbunden ist und daher auf dem Potential der Pulsspannung liegt. Das Ausgangssignal der Sensorschaltung wird zwischen dem Emitter des zweiten pnp-Transistors und dem mit dem Minuspol der Betriebsspannung verbundenen Bezugspotential abgegriffen.

Diese Schaltungsanordnung baut auf der in der bereits genannten DE 10 2005 001 777 A1 der Anmelderin auf, bei welcher die erfindungsgemäße Sensorschaltung in besonders vorteilhafter Weise einsetzbar ist. Analog zu der in der DE 10 2005 001 777 A1 beschriebenen Schaltungsanordnung kann auch hier die Schaltungsanordnung mehrere solcher Sensorschaltungen für jeweils einen kapazitiven Berührungsschalter der Erfindung enthalten.

In einer bevorzugten Ausführungsform ist eine Messelektrode, mit einer Sensorfläche gekoppelt, wobei die Messelektrode auf einer Leiterplatte angeordnet ist und auf einem ersten Potential liegt; und weiter eine Zusatzelektrode, die nahe der Messelektrode ebenfalls auf der Leiterplatte angeordnet ist, von der Messelektrode elektrisch isoliert ist und auf einem von dem ersten Potential verschiedenen zweiten Potential liegt.

Die Anordnung einer Zusatzelektrode, die nahe der Messelektrode auf der Leiterplatte von der Messelektrode elektrisch isoliert angeordnet ist und auf einem von dem ersten Potential der Messelektrode verschiedenen zweiten Potential liegt, bewirkt eine Abschirmung der Messelektrode, was wiederum zu einem störungsunempfindlicheren Ausgangssignal einer zugehörigen Sensorschaltung führt.

In einer Ausgestaltung der Erfindung sind die Messelektrode und die Zusatzelektrode derart angeordnet, dass die Zusatzelektrode die Messelektrode zum Beispiel streifenförmig und/oder flächenförmig umgibt.

In einer weiteren Ausgestaltung der Erfindung ist die Messelektrode auf einer Seite einer zweiseitig beschichteten Leiterplatte angeordnet und die Zusatzelektrode ist auf der anderen Seite der Leiterplatte im Wesentlichen gegenüber der Messelektrode angeordnet. Dabei entspricht die Zusatzelektrode in ihrer Größe der Messelektrode oder ist großflächiger als die Messelektrode ausgebildet. Weiter kann die Zusatzelektrode in diesem Fall auch zusätzlich auf der gleichen Seite der Leiterplatte wie die Messelektrode angeordnet sein und diese dort streifenförmig und/oder flächenförmig umgeben.

In einer bevorzugten Ausgestaltung der Erfindung entspricht die Kontur der Zusatzelektrode der Kontur der Messelektrode, d.h. beide Elektroden sind zum Beispiel kreisförmig oder rechteckig ausgebildet.

Das zweite Potential, auf dem die Zusatzelektrode liegt, ist vorzugsweise ein von Masse verschiedenes Potential.

In einer Ausgestaltung der Erfindung ist die Messelektrode über ein elastisches Druckelement, wie zum Beispiel eine metallische Feder, elektrisch leitend mit der Sensorfläche verbunden.

In einer weiteren Ausgestaltung der Erfindung ist die Sensorfläche hinter einer elektrisch isolierenden, zumindest teilweise lichtdurchlässigen Bedienfeldplatte wie beispielsweise einer Glaskeramikplatte eines Kochfeldes angeordnet.

In einer besonders vorteilhaften Weiterbildung der Erfindung ist die Sensorfläche selbst die Messelektrode und ist unmittelbar hinter der Bedienfeldplatte angeordnet. Durch diese Anordnung reduziert sich die Anzahl der Bauteile.

Der Gegenstand der vorliegenden Erfindung ist in vorteilhafter Weise bei einer Bedienungseinrichtung für ein elektronisches Haushaltsgerät, wie einem Kochherd, einem Kochfeld, einem Mikrowellenofen, einer Spülmaschine, einer Waschmaschine, einem Wäschetrockner und dergleichen, anwendbar.

Obige sowie weitere Merkmale und Vorteile der Erfindung werden aus der nachfolgenden Beschreibung bevorzugter, nicht-einschränkender Ausführungsbeispiele unter Bezugnahme auf die beiliegenden Zeichnungen besser verständlich. Darin zeigen:
- Fig. 1: eine schematische Schnittansicht zur Erläuterung des Grundaufbaus eines kapazitiven Berührungsschalters gemäß der vorliegenden Erfindung;
- Fig. 2: eine schematisierte Draufsicht eines kapazitiven Berührungsschalters gemäß einem ersten Ausführungsbeispiel;
- Fig. 3: eine schematisierte Draufsicht eines kapazitiven Berührungsschalters gemäß einem zweiten Ausführungsbeispiel;
- Fig. 4: eine schematisierte Draufsicht eines kapazitiven Berührungsschalters gemäß einem dritten Ausführungsbeispiel;
- Fig. 5: eine schematisierte Draufsicht eines kapazitiven Berührungsschalters gemäß einem vierten Ausführungsbeispiel;
- Fig. 6: eine schematisierte Schnittansicht eines kapazitiven Berührungsschalters gemäß einem fünften Ausführungsbeispiel;
- Fig. 7: eine schematisierte Schnittansicht eines kapazitiven Berührungsschalters gemäß einem sechsten Ausführungsbeispiel;
- Fig. 8: eine schematisierte Schnittansicht eines kapazitiven Berührungsschalters gemäß einem siebten Ausführungsbeispiel; und
- Fig. 9: eine Schaltungsanordnung für einen kapazitiven Berührungsschalter gemäß der vorliegenden Erfindung.

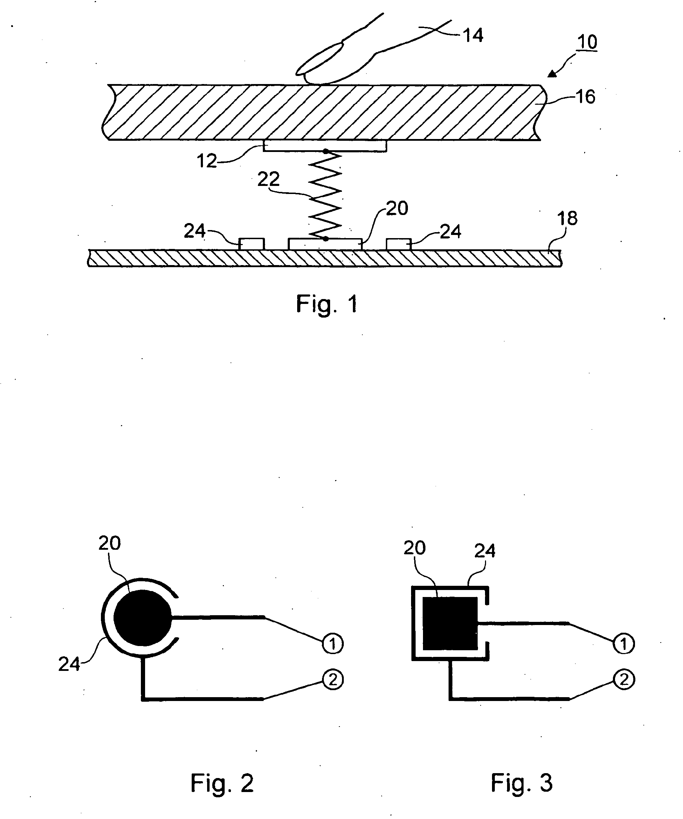

Anhand von Fig. 1 wird zunächst der Grundaufbau eines kapazitiven Berührungsschalters der vorliegenden Erfindung erläutert. Anschließend werden Bezug nehmend auf Fig. 2 bis 8 verschiedene bevorzugte Ausführungsformen dieses kapazitiven Berührungsschalters beschrieben.

Der kapazitive Berührungsschalter 10 enthält eine Sensorfläche 12 als Teil eines kapazitiven Sensorelements, das zusammen mit einem Benutzer bzw. seinem / ihrem Finger 14 über eine ein Dielektrikum bildende Bedienfeldplatte 16, wie zum Beispiel eine Glaskeramikplatte eines Kochfeldes oder dergleichen, eine Kapazität Cs bildet. Diese Kapazität Cs des Sensorelements ist entsprechend dem Betätigen, d.h. dem Berühren oder Nicht-Berühren des kapazitiven Berührungsschalters 10 variabel. Die Bedienfeldplatte 16 ist in üblicher Weise elektrisch isolierend und zumindest teilweise lichtdurchlässig ausgebildet, sodass der bereich der Sensorfläche 12 zum Beispiel hinterleuchtet werden kann.

Hinter der Bedienfeldplatte 16 ist in einem Abstand eine Leiterplatte 18 angeordnet. Auf dieser Leiterplatte 18 befindet sich auf der der Sensorfläche 12 zugewandten Seite eine Messelektrode 20. Die Messelektrode 20 ist über ein elastisches Druckelement 22 wie beispielsweise eine Metallfeder elektrisch leitend mit der Sensorfläche verbunden, sodass einerseits die Sensorfläche 22 in engen Kontakt gegen die Bedienfeldplatte 16 gedrückt wird und andererseits die Sensorfläche 12 und die Messelektrode 20 auf dem gleichen Potential (erstes Potential der Erfindung) liegen.

Die Messelektrode 20 ist mit einer später beschriebenen Sensorschaltung verbunden, welche ebenfalls auf der Leiterplatte montiert sein kann. Diese Sensorschaltung erzeugt in Abhängigkeit von dem Kapazitätswert des kapazitiven Sensorelements ein Ausgangssignal Out, aus dem eine entsprechende Auswerteschaltung bestimmen kann, ob der kapazitive Berührungsschalter 10 betätigt wird oder nicht.

Bis hierher entspricht der kapazitive Berührungsschalter 10 einem herkömmlichen Berührungsschalter. Wie in Fig. 1 dargestellt, enthält der Berührungsschalter 10 weiter eine Zusatzelektrode 24, die nahe der Messelektrode 20 ebenfalls auf der Leiterplatte 18 angebracht ist. Diese Zusatzelektrode 24 ist von der Messelektrode 20 elektrisch isoliert und liegt auf einem von der Messelektrode 20 verschiedenen Potential (zweites Potential der Erfindung). Mit der Zusatzelektrode 24 wird eine Abschirmung der Messelektrode 20 auf der Leiterplatte 18 bewirkt, was wiederum zu einem ungestörteren Ausgangssignal Out der Sensorschaltung und damit zu einer besseren Auswertbarkeit in der Auswerteschaltung führt.

Die Zusatzelektrode 24 bildet im Gegensatz zur Messelektrode 20 kein kapazitives Sensorelement, da sie ausreichend von der Bedienfeldplatte 16 beabstandet und mit keiner entsprechenden Sensorfläche verbunden ist. Optional kann zwischen der Sensorfläche 12 des kapazitiven Sensorelements und der Zusatzelektrode 24 zusätzlich ein Element aus einem elektrisch isolierenden Material angeordnet werden.

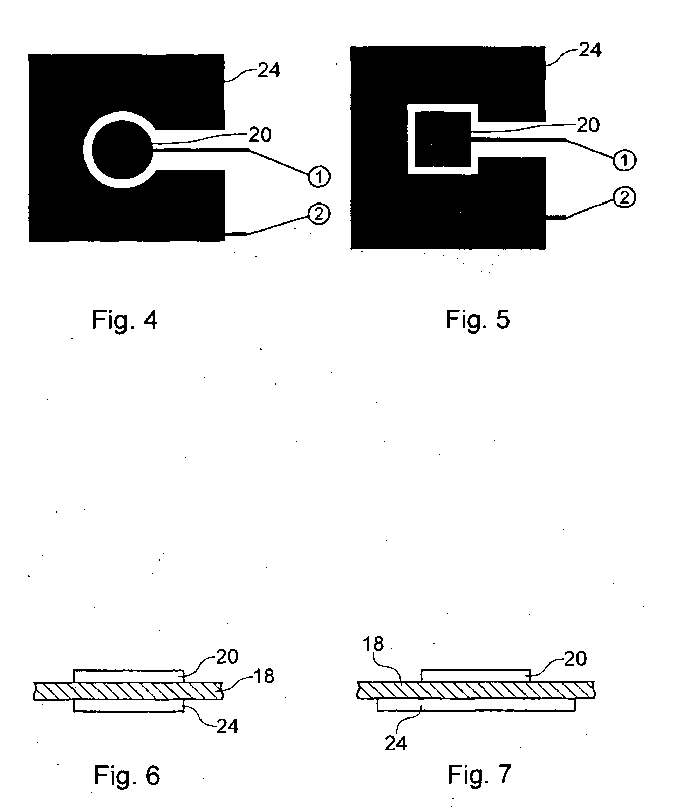

Für die Anordnung der Messelektrode 20 und der Zusatzelektrode 24 sind verschiedene Ausführungsformen vorgesehen. Im Fall einer einseitig beschichteten Leiterplatte 18 sind die Zusatzelektrode 24 und die Messelektrode 20 auf der gleichen Seite der Leiterplatte 18, bevorzugt auf der der Sensorfläche 12 zugewandten Seite angeordnet. Die Zusatzelektrode 24 kann die Messelektrode 20 beispielsweise streifenförmig (siehe Fig. 2 und 3) oder flächenförmig (siehe Fig. 4 und 5) umgeben. Dabei entspricht die Kontur der Zusatzelektrode 24 im Wesentlichen der Kontur der Messelektrode 20, zum Beispiel sind beide kreisförmig, quadratisch oder rechteckig ausgebildet.

Im Fall einer zweiseitig beschichteten Leiterplatte 18 ist die Messelektrode 20 zum Beispiel auf einer Seite der Leiterplatte 18, vorzugsweise der der Sensorfläche 12 zugewandten Seite, angeordnet, während die Zusatzelektrode 24 auf der anderen Seite der Leiterplatte 18 der Messelektrode 20 gegenüber liegend angeordnet ist. Dabei kann die Zusatzelektrode 24 in ihrer Größe der Messelektrode 20 entsprechen (siehe Fig. 6) oder großflächiger als die Messelektrode 20 ausgebildet sein (siehe Fig. 7).

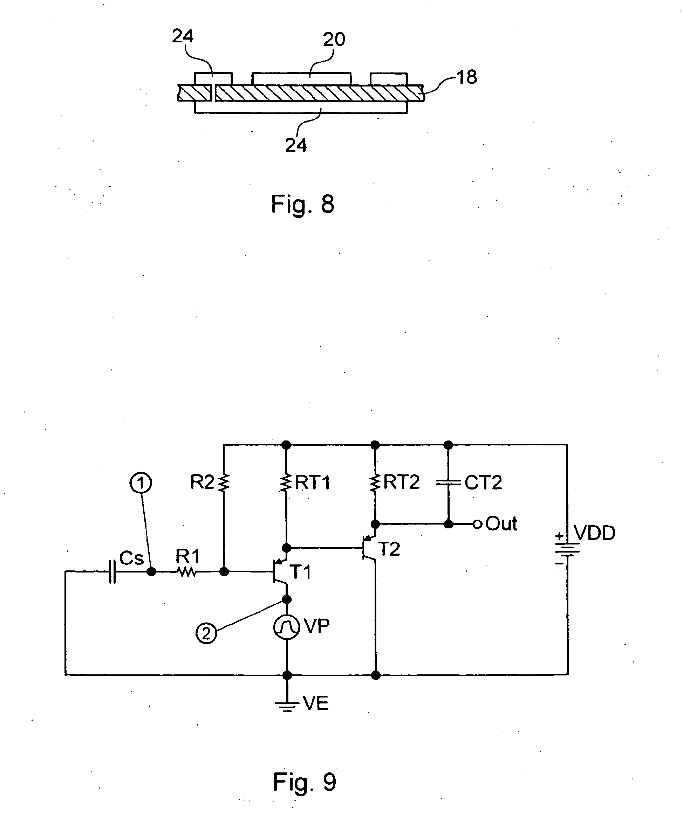

Wie in Fig. 8 angedeutet, kann die Zusatzelektrode 24 zusätzlich auch auf der gleichen Seite der Leiterplatte 18 wie die Messelektrode 20 vorgesehen sein. Der Teil der Zusatzelektrode 24 auf der gleichen Seite der Leiterplatte 18 ist dann zum Beispiel analog einem der Ausführungsbeispiele von Fig. 2 bis 5 ausgebildet, während der Teil der Zusatzelektrode 24 auf der anderen Seite der Leiterplatte 18 vorzugsweise großflächiger als die Messelektrode 20 ausgebildet ist. Bei diesem Ausführungsbeispiel von Fig. 8 kann offensichtlich die größte Abschirmwirkung für die Messelektrode 20 erzielt werden.

Auch in den in Fig. 6 bis 8 veranschaulichten Ausführungsbeispielen entspricht die Kontur der Zusatzelektrode 24 jeweils im Wesentlichen der Kontur der Messelektrode 20.

Ohne explizit dargestellt zu sein, ist es auch denkbar, die Zusatzelektrode 24 in mehr als zwei Ebenen nach den obigen Gesichtspunkten um die Messelektrode 20 herum auf der Leiterplatte 18 anzuordnen.

Die Zusatzelektrode 24 bewirkt auf einfache Weise eine Verbesserung des Ausgangssignals Out einer mit der Messelektrode 20 verbundenen Sensorschaltung. Gleichzeitig ist die Gestaltung der Zusatzelektrode 24 unabhängig von der exakten Ausgestaltung des kapazitiven Sensorelements, d.h. zum Beispiel von eventuelle eingesetzten Überbrückungs- oder Koppelgliedern zu der abgesetzten Bedienfeldplatte 16. Während die Erfindung oben anhand eines kapazitiven Berührungsschalters 10 mit einer von der Sensorfläche 12 beabstandeten Messelektrode 20 erläutert worden ist, ist es im Rahmen der Erfindung auch möglich, die Sensorfläche 12 selbst direkt als Messelektrode zu verwenden, mit anderen Worten, die Leiter-platte 18 unmittelbar hinter die Bedienfeldplatte 16 zu setzen.

Wie bereits erwähnt, ist der kapazitive Berührungsschalter 10 nach einem der oben beschriebenen Ausführungsformen mit einer Schaltungsanordnung verbunden, die eine Betätigung des Berührungsschalters 10 erfasst und einen entsprechenden Schaltvorgang auslöst. Ein bevorzugtes Ausführungsbeispiel einer solchen Schaltungsanordnung wird nun Bezug nehmend auf Fig. 9 näher erläutert. Die Schaltungsanordnung von Fig. 9 entspricht dabei im Wesentlichen der in der deutschen Anmeldung Nr. 10 2005 001 777.0 beschriebenen Schaltungsanordnung.

Das kapazitive Sensorelement mit der Kapazität Cs bzw. die mit diesem gekoppelte Messelektrode 20 ist über einen ersten Widerstand R1 mit der Basis eines ersten pnp-Transistors T1 verbunden, wie durch einen Anschluss ① in Fig. 9 angegeben. Die Basis des ersten pnp-Transistors T1 ist ferner über einen zweiten Widerstand R2 mit einer Betriebsspannung VDD verbunden, die von einer ersten Spannungsquelle zur Verfügung gestellt wird. Der Emitter des ersten pnp-Transistors T1 liegt über einen dritten Widerstand RT1 ebenfalls an der Betriebsspannung VDD.

Der Kollektor des ersten pnp-Transistors T1 ist mit einer Pulsspannung VP verbunden, die von einer zweiten Spannungsquelle, zum Beispiel in Form eines Ausgangspins eines Mikrocontrollers zur Verfügung gestellt wird. Der Emitter des ersten pnp-Transistors T1 ist weiter mit der Basis eines zweiten pnp-Transistors T2 verbunden. Der Kollektor dieses zweiten pnp-Transistors T2 liegt auf der Bezugsspannung der Schaltungsanordnung, und der Emitter dieses zweiten pnp-Transistors T2 ist über eine Parallelschaltung aus einem vierten Widerstand RT2 und einer Kapazität CT2 mit der Betriebsspannung VDD verbunden.

Die Bezugsspannung aller Schaltungsteile, und auch die Bezugspotentiale der Betriebsspannung VDD und der Pulsspannung VP sind bevorzugt mit dem Massepotential VE verbunden.

Die Zusatzelektrode 24 ist mit dem Kollektor des ersten pnp-Transistors T1 verbunden, wie durch den Anschluss ② in Fig. 9 angegeben. Damit liegt die Zusatzelektrode 24 auf dem Potential der Pulsspannung VP, d.h. insbesondere auf einem anderen Potential als die Messelektrode 20. Es hat sich dabei herausgestellt, dass es von Vorteil ist, wenn die Zusatzelektrode 24 nicht mit dem Massepotential VE, sondern mit der Pulsspannung VP verbunden ist.

Das Ausgangssignal Out der Sensorschaltung wird am Emitter des zweiten pnp-Transistors T2 abgegriffen und der Auswerteschaltung, d.h. zum Beispiel einem ADC-Eingang eines Mikrocontrollers zugeführt.

Auf der Basis dieser Schaltungsanordnung von Fig. 9 für einen kapazitiven Berührungsschalter 10 lassen sich auf einfache Weise Schaltungsanordnungen mit mehreren Sensorschaltungen aufbauen, die jeweils einem von mehreren kapazitiven Berührungsschaltern zugeordnet sind.

Da der Aufbau und die Funktionsweise dieser Schaltungsanordnung von Fig. 9 sowie auch der Aufbau dieser Schaltungsanordnung mit mehreren Sensorschaltungen in der deutschen Anmeldung Nr. 10 2005 001 777.0 der Anmelderin ausführlich erläutert sind, wird an dieser Stelle auf eine detailliertere Beschreibung verzichtet. Stattdessen wird diesbezüglich vollinhaltlich auf die DE 10 2005 001 777.0 Bezug genommen.

Der kapazitive Berührungsschalter des oben beschriebenen Aufbaus ist in vorteilhafter Weise bei einer Bedienungseinrichtung für ein elektronisches Haushaltsgerät, wie beispielsweise einem Kochherd, einem Kochfeld, einem Mikrowellenofen, einer Spülmaschine, einer Waschmaschine, einem Wäschetrockner und dergleichen, anwendbar.

## Patentansprüche

1. Kapazitiver Berührungsschalter (10), mit einer Sensorfläche (12) als Teil eines kapazitiven Sensorelements, dessen Kapazität (Cs) sich bei Berührung verändert, und einer Messelektrode (20), die mit der Sensorfläche (12) gekoppelt ist und auf einer Leiterplatte (18) angeordnet ist, sowie mit einer Schaltungsanordnung mit einer den Berührungsschalter (10) enthaltenden Sensorschaltung und einer Auswerteschaltung, der ein Ausgangssignal (Out) der Sensorschaltung zum Bestimmen, ob der Berührungsschalter betätigt wird oder nicht, zugeführt wird, wobei die Sensorschaltung eine erste Spannungsquelle zum Liefern einer Betriebsspannung (VDD),
einen ersten pnp-Transistor (T1), dessen Basis über einen ersten Widerstand (R1) mit der Messelektrode (20) und über einen zweiten Widerstand (R2) mit einem Pluspol der Betriebsspannung (VDD) verbunden ist und dessen Emitter über einen dritten Widerstand (RT1) auch mit dem Pluspol der Betriebsspannung (VDD) verbunden ist,
eine zweite Spannungsquelle zum Liefern einer Pulsspannung (VP), die zwischen dem Kollektor des ersten pnp-Transistors (T1) und einem mit dem Minuspol der Betriebsspannung (VDD) verbundenen Bezugspotentials (VE) angelegt ist, und einen zweiten pnp-Transistor (T2), dessen Basis mit dem Emitter des ersten pnp-Transistors (T1) verbunden ist, dessen Kollektor auch mit dem Bezugspotential (VE) verbunden ist und dessen Emitter über eine Parallelschaltung aus einem vierten Widerstand (RT2) und einer Kapazität (CT2) mit dem Pluspol der Betriebsspannung (VDD) verbunden ist,
aufweist;
wobei eine Zusatzelektrode (24) mit dem Kollektor des ersten pnp-Transistors (T1) verbunden ist; und
das Ausgangssignal (Out) der Sensorschaltung zwischen dem Emitter des zweiten pnp-Transistors (T2) und dem mit dem Minuspol der Betriebsspannung (VDD) verbundenen Bezugspotentials (VE) abgegriffen wird.

2. Berührungsschalter nach Anspruch 1,
**dadurch gekennzeichnet,**
**dass** die mit einer Sensorfläche (12) gekoppelte Messelektrode (20) auf einer Leiterplatte (18) angeordnet ist und auf einem ersten Potential liegt,
wobei ebenfalls auf der Leiterplatte (18) nahe der Messelektrode (20) eine Zusatzelektrode (24) des Berührungsschalters (10) angeordnet ist, die von der Messelektrode (20) elektrisch isoliert ist und auf einem von dem ersten Potential verschiedenen zweiten Potential liegt.

3. Berührungsschalter nach Anspruch 2,
**dadurch gekennzeichnet,**
**dass** die Zusatzelektrode (24) die Messelektrode (20) streifenförmig und/oder flächenförmig umgibt.

4. Berührungsschalter nach Anspruch 1,
**dadurch gekennzeichnet,**
**dass** die Messelektrode (20) auf einer Seite der Leiterplatte (18) angeordnet ist und die Zusatzelektrode (24) auf der anderen Seite der Leiterplatte (18) gegenüber der Messelektrode (20) angeordnet ist.

5. Berührungsschalter nach Anspruch 4,
**dadurch gekennzeichnet,**
**dass** die Zusatzelektrode (24) in ihrer Größe der Messelektrode (20) entspricht oder großflächiger als die Messelektrode (20) ausgebildet ist.

6. Berührungsschalter nach Anspruch 4 oder 5,
**dadurch gekennzeichnet,**
**dass** die Zusatzelektrode (24) zusätzlich auf der gleichen Seite der Leiterplatte (18) wie die Messelektrode (20) angeordnet ist und diese streifenförmig und/ oder flächenförmig umgibt.

7. Berührungsschalter nach einem der vorherigen Ansprüche,
**dadurch gekennzeichnet,**
**dass** die Kontur der Zusatzelektrode (24) der Kontur der Messelektrode (20) entspricht.

8. Berührungsschalter nach einem der vorherigen Ansprüche,
**dadurch gekennzeichnet,**
**dass** das zweite Potential, auf dem die Zusatzelektrode (24) liegt, ein von Masse verschiedenes Potential ist.

9. Berührungsschalter nach einem der vorherigen Ansprüche,
**dadurch gekennzeichnet,**
**dass** die Messelektrode (20) über ein elastisches Druckelement (22) elektrisch leitend mit der Sensorfläche (12) verbunden ist.

10. Berührungsschalter nach einem der vorherigen Ansprüche,
**dadurch gekennzeichnet,**
**dass** die Sensorfläche (12) hinter einer elektrisch isolierenden, zumindest teilweise lichtdurchlässigen Bedienfeldplatte (16) angeordnet ist.

11. Berührungsschalter nach einem der Ansprüche 1 bis 8 oder 10,
**dadurch gekennzeichnet,**
**dass** die Sensorfläche (12) selbst die Messelektrode (20) ist und unmittelbar hinter der Bedienfeldplatte (16) angeordnet ist.

12. Bedienungseinrichtung für ein elektronisches Haushaltsgerät, mit wenigstens einem kapazitiven Berührungsschalter nach einem der Ansprüche 1 bis 11.

## Claims

1. Capacitive touch switch (10), comprising a sensor area (12) as part of a capacitive sensor element, the capacitance (Cs) of which changes when touched, and a measuring electrode (20), which is coupled to the sensor area (12) and is arranged on a printed circuit board (18), and also comprising a circuit arrangement comprising a sensor circuit containing the touch switch (10), and comprising an evaluation circuit, which is fed an output signal (Out) of the sensor circuit for determining whether or not the touch switch is actuated, wherein the sensor circuit has a first voltage source for supplying an operating voltage (VDD),
a first pnp transistor (T1), the base of which is connected to the measuring electrode (20) via a first resistor (R1) and to a positive pole of the operating voltage (VDD) via a second resistor (R2) and the emitter of which is also connected to the positive pole of the operating voltage (VDD) via a third resistor (RT1),
a second voltage source for supplying a pulse voltage (VP), which is applied between the collector of the first pnp transistor (T1) and a reference potential (VE) connected to the negative pole of the operating voltage (VDD),
and a second pnp transistor (T2), the base of which is connected to the emitter of the first pnp transistor (T1), the collector of which is also connected to the reference potential (VE) and the emitter of which is connected to the positive pole of the operating voltage (VDD) via a parallel circuit comprising a fourth resistor (RT2) and a capacitance (CT2);
an additional electrode (24) being connected to the collector of the first pnp transistor (T1); and
the output signal (Out) of the sensor circuit being tapped off between the emitter of the second pnp transistor (T2) and the reference potential (VE) connected to the negative pole of the operating voltage (VDD).

2. Touch switch according to Claim 1,
**characterized**
**in that** the measuring electrode (20) coupled to a sensor area (12) is arranged on a printed circuit board (18) and is at a first potential, an additional electrode (24) of the touch switch (10) likewise being arranged on the printed circuit board (18) near to the measuring electrode (20), said additional electrode being electrically insulated from the measuring electrode (20) and being at a second potential, which is different from the first potential.

3. Touch switch according to Claim 2,
**characterized**
**in that** the additional electrode (24) surrounds the measuring electrode (20) in strip form and/or in areal form.

4. Touch switch according to Claim 1,
**characterized**
**in that** the measuring electrode (20) is arranged on one side of the printed circuit board (18) and the additional electrode (24) is arranged on the other side of the printed circuit board (18) opposite the measuring electrode (20).

5. Touch switch according to Claim 4,
**characterized**
**in that** the additional electrode (24) corresponds to the measuring electrode (20) in terms of its size or is formed with a larger area than the measuring electrode (20).

6. Touch switch according to Claim 4 or 5,
**characterized**
**in that** the additional electrode (24) is additionally arranged on the same side of the printed circuit board (18) as the measuring electrode (20) and surrounds the latter in strip form and/or in areal form.

7. Touch switch according to one of the preceding claims,
**characterized**
**in that** the contour of the additional electrode (24) corresponds to the contour of the measuring electrode (20).

8. Touch switch according to one of the preceding claims,
**characterized**
**in that** the second potential, which is the potential of the additional electrode (24), is a potential that is different from ground.

9. Touch switch according to one of the preceding claims,
**characterized**
**in that** the measuring electrode (20) is electrically conductively connected to the sensor area (12) via an elastic compression element (22).

10. Touch switch according to one of the preceding claims,
**characterized**
**in that** the sensor area (12) is arranged behind an electrically insulating, at least partly light-transmissive control panel plate (16).

11. Touch switch according to one of Claims 1 to 8 or 10,
**characterized**
**in that** the sensor area (12) itself is the measuring electrode (20) and is arranged directly behind the control panel plate (16).

12. Control device for an electronic domestic appliance, comprising at least one capacitive touch switch according to one of Claims 1 to 11.

## Revendications

1. Commutateur capacitif de contact (10) qui présente
une surface de détection (12) qui fait partie d'un élément capacitif de détection dont la capacité (Cs) se modifie en cas de contact et
une électrode de mesure (20) couplée à la surface de détection (12), disposée sur une carte de circuit (18),
ainsi qu'un circuit qui présente un circuit de détection qui contient le commutateur de contact (10) et un circuit d'évaluation auquel est amené un signal de sortie (Out) du circuit de détection pour déterminer si le commutateur de contact est actionné ou non,
le circuit de détection présentant une première source de tension qui délivre une tension de service (VDD), un premier transistor pnp (T1) dont la base est reliée à l'électrode de mesure (20) par une première résistance (R1) et au pôle positif de la tension d'alimentation (VDD) par une deuxième résistance (R2) et dont l'émetteur est également relié au pôle positif de la tension de service (VDD) par l'intermédiaire d'une troisième résistance (RT1),
une deuxième source de tension qui délivre une tension pulsée (VP) appliquée entre le collecteur du premier transistor pnp (T1) et un potentiel de référence (VE) relié au pôle négatif de la tension de service (VDD),
un deuxième transistor pnp (T2) dont la base est reliée à l'émetteur du premier transistor pnp (T1), dont le collecteur est également relié au potentiel de référence (VE) et dont l'émetteur est relié au pôle positif de la tension d'alimentation (VDD) par l'intermédiaire d'un circuit parallèle constitué d'une quatrième résistance (RT2) et d'une capacité (CT2),
une électrode supplémentaire (24) étant reliée au collecteur du premier transistor pnp (T1) et
le signal de sortie (Out) du circuit de détection étant prélevé entre l'émetteur du deuxième transistor pnp (T2) et le potentiel de référence (VE) relié au pôle négatif de la tension d'alimentation (VDD).

2. Commutateur de contact selon la revendication 1, **caractérisé en ce que** l'électrode de mesure (20) couplée à une surface de détection (12) est disposée sur une carte de circuit (18) et est placée à un premier potentiel, une électrode supplémentaire (24) du commutateur de contact (10) étant également disposée sur la carte de circuit (18) à proximité de l'électrode de mesure (20), étant électriquement isolée de l'électrode de mesure (20) et étant placé à un deuxième potentiel différent du premier potentiel.

3. Commutateur de contact selon la revendication 2, **caractérisé en ce que** l'électrode supplémentaire (24) entoure l'électrode de mesure (20) en forme de ruban et/ou sous la forme d'une surface.

4. Commutateur de contact selon la revendication 1, **caractérisé en ce que** l'électrode de mesure (20) est disposée sur un côté de la carte de circuit (18) et **en ce que** l'électrode supplémentaire (24) est disposée sur l'autre côté de la carte de circuit (18), face à l'électrode de mesure (20).

5. Commutateur de contact selon la revendication 4, **caractérisé en ce que** l'électrode supplémentaire (24) a une taille qui correspond à celle de l'électrode de mesure (20) ou a une surface plus grande que celle de l'électrode de mesure (20).

6. Commutateur de contact selon les revendications 4 ou 5, **caractérisé en ce que** l'électrode supplémentaire (24) est de plus disposée sur le même côté de la carte de circuit (18) que l'électrode de mesure (20) et entoure cette dernière en forme de ruban et/ou en forme de surface.

7. Commutateur de contact selon l'une des revendications précédentes, **caractérisé en ce que** le contour de l'électrode supplémentaire (24) correspond au contour de l'électrode de mesure (20).

8. Commutateur de contact selon l'une des revendications précédentes, **caractérisé en ce que** le deuxième potentiel auquel est placée l'électrode supplémentaire (24) est un potentiel différent de celui de la masse.

9. Commutateur de contact selon l'une des revendications précédentes, **caractérisé en ce que** l'électrode de mesure (20) est reliée de manière électriquement conductrice à la surface de détection (12) par l'intermédiaire d'un élément élastique de poussée (22).

10. Commutateur de contact selon l'une des revendications précédentes, **caractérisé en ce que** la surface de détection (12) est disposée derrière une carte de commande (16) électriquement isolée et au moins en partie transparente vis-à-vis de la lumière.

11. Commutateur de contact selon l'une des revendications 1 à 8 ou 10, **caractérisé en ce que** la surface de détection (12) forme l'électrode de mesure (20) proprement dite et est disposée directement derrière la carte de commande (16).

12. Dispositif de commande d'un appareil domestique électronique qui présente au moins un commutateur capacitif de contact selon l'une des revendications 1 à 11.
